Europäisches Patentamt

European Patent Office

Office européen des brevets

(11) Publication number: **0 045 848**
**B1**

(12) EUROPEAN PATENT SPECIFICATION

(45) Date of publication of patent specification: **21.11.84**

(21) Application number: **81105228.1**

(22) Date of filing: **06.07.81**

(51) Int. Cl.³: **H 01 L 29/06,** H 01 L 27/08, H 01 L 21/76

(54) Planar semiconductor integrated circuits including improved bipolar transistor structures and method of fabricating such circuits.

(30) Priority: **08.08.80 US 176386**

(43) Date of publication of application:
**17.02.82 Bulletin 82/07**

(45) Publication of the grant of the patent:
**21.11.84 Bulletin 84/47**

(84) Designated Contracting States:
**DE FR GB IT**

(56) References cited:
FR-A-2 369 652
GB-A-1 352 044
US-A-3 904 450
US-A-4 098 618

IBM TECHNICAL DISCLOSURE BULLETIN, Vol. 21, No. 7, December 1978 New York CHANG et al. "Self-Aligned Bipolar Transistor" pages 2761 to 2762
IBM TECHNICAL DISCLOSURE BULLETIN, Vol. 21, Nr. 4, September 1978, New York HARDER et al. "Gas Mixture Control Permits Nonselective Reactive Ion Etch" pages 1518 to 1519

(73) Proprietor: **International Business Machines Corporation**
**Old Orchard Road**
**Armonk, N.Y. 10504 (US)**

(72) Inventor: **Reisman, Arnold**
**2294 Van Cortlandt Circle**
**Yorktown Heights New York 10598 (US)**
Inventor: **Silvestri, Victor Joseph**
**69 Byram Lake Road**
**Mount Kisco New York 10549 (US)**
Inventor: **Tang, Denny Duan-Lee**
**RD 2, Mohawk Lane**
**Yorktown Heights New York 10598 (US)**
Inventor: **Wiedmann, Siegfried Kurt**
**Im Himmel 64A**
**D-7000 Stuttgart (DE)**
Inventor: **Yu, Hwa Nien**
**2849 Hickory Street**
**Yorktown Heights New York 10598 (US)**

(74) Representative: **Hobbs, Francis John**
**IBM United Kingdom Patent Operations Hursley Park**
**Winchester, Hants, SO21 2JN (GB)**

EP 0 045 848 B1

## Description

This invention relates to planar semiconductor integrated circuits including bipolar transistors and to methods of fabricating such circuits.

In conventional integrated circuits, the area of the top junction of vertical bipolar transistors is always smaller than the area of the lower junction due to the contact area to the base region, and/or the magnitude of alignment tolerances needed. Therefore high performance is obtainable only when such a device is operated in a downward mode. Even then, however, parasitic diode effects limit the performance of the transistor. Parasitic diodes also affect the performance of lateral transistors.

The article on pages 2761 to 2762 of the IBM Technical Disclosure Bulletin, Volume 21, no. 7, December 1978 entitled "Self-aligned Bipolar Transistor", discloses a self-aligned bipolar transistor comprising a buried insulating region with an opening having parallel side walls. The insulating region confines an N collector region within the opening which is contiguous with the same conductivity type semiconductor region lying underneath the insulating region. An outer semiconductor layer of P conductivity type is provided over the insulating region and PN junctions of a symmetrical bi-polar transistor structure are formed in a region defined in the outer layer by the opening in the insulating region. The PN junctions have substantially the same areas.

Bipolar transistor technology has recently been enhanced by an improved process utilizing the concept of simultaneous growth of epitaxial silicon on single crystal silicon and polycrystalline silicon on silicon dioxide. This results in a transistor structure with somewhat reduced parasitic diode effects. This concept is described by Davies et al in the article entitled "Poly I²L — A High-Speed-Linear-Compatible Structure", IEEE J. Solid State Circuits, Vol. SC-12, No. 4, August 1977, pp. 367—375.

The present invention seeks to provide an integrated circuit including bipolar transistor structures in which the formation of parasitic diodes is avoided.

According to one aspect of the invention, there is provided a planar semiconductor integrated circuit including a layer of isolating material disposed over a semiconductor substrate of one conductivity type, the isolating layer being provided with a first hole therethrough having substantially parallel sidewalls and containing semiconductor of the opposite conductivity type, an outer layer of semiconductor of said one conductivity type overlying the isolating layer and a symmetrical vertical bipolar transistor structure comprising a pair of PN junctions formed in a region defined in said outer layer of semiconductor by the hole in the isolating layer, the PN junctions being of substantially equal area and confined to the intrinsic region of the transistor, the circuit being characterised by further including a doped region of semiconductor of said opposite conductivity type formed in the substrate in such a position that it is contiguous with the semiconductor of said opposite conductivity type in the first hole in the isolating layer, and by further including a second symmetrical bipolar transistor structure comprising a pair of PN junctions formed in a region defined in said outer layer of semiconductor by a second hole in the isolating layer, the second hole having substantially parallel sidewalls and containing semiconductor of said opposite conductivity type contiguous with said doped region, the second symmetrical bipolar transistor structure being a lateral transistor structure including a base region of said opposite conductivity type formed in said outer layer and overlying and contiguous with the semiconductor of said opposite conductivity type contained in the second hole in the isolating layer, the PN junctions between the base region and the semiconductor of said one conductivity type of said outer layer being substantially perpendicular to the outer layer and being of substantially equal area.

According to a further aspect of the invention, a method of fabricating a planar semiconductor integrated circuit including a vertical bipolar transistor having first and second PN junctions of substantially equal area and a lateral bipolar transistor having first and second PN junctions of substantially equal area comprises the steps a to k defined in claim 6.

How the invention can be carried out will now be described by way of example, with reference to the accompanying drawings, in which:—

FIG. 1.1 is a schematic side view of a conventional vertical npn transistor and FIG. 1.2 is an equivalent circuit therefor;

FIG. 2.1 is a schematic side view of a conventional lateral pnp transistor and FIG. 2.2 is an equivalent circuit therefor;

FIG. 3 is a schematic side view of a planar semiconductor integrated circuit including a vertical npn transistor and a lateral pnp transistor according to the invention; and

FIGS. 4.1 through 4.12 are schematic diagrams illustrating the steps in an embodiment of a fabrication method for forming a bipolar transistor structure according to the present invention.

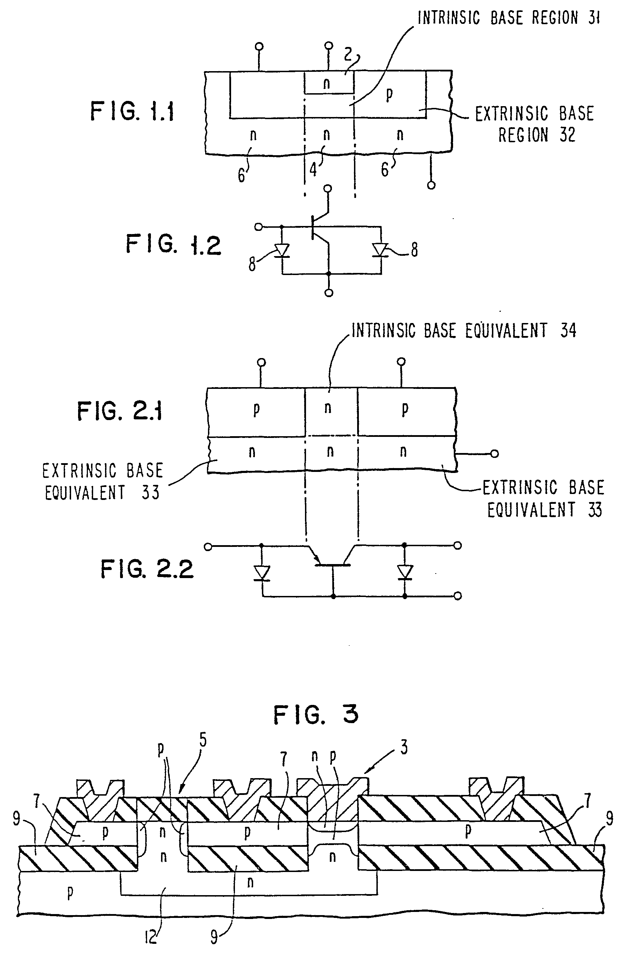

In a conventional vertical bipolar transistor as illustrated in FIG. 1.1, the top junction is always smaller than the lower junction by the amount of alignment tolerance and the contact area to the base region. The transistor of FIG. 1.1 provides high performance only when it is operated downwards, that is, when the top n+ region 2 is used as the emitter. When the transistor of FIG. 1.1 is operated upwards, that is, when the lower n+ region 4 is used as the emitter such as in Merged-Transistor-Logic or

I²L circuits, the current gain is lower (by approximately a factor of three) and the switching speed is slower (by approximately a factor of three) due to the existence of the parasitic diodes formed by the area 6 outside the intrinsic base region 31 of the lower junction where area 6 contacts the extrinsic base region area 32 as shown in the equivalent circuit of FIG. 1.2 wherein the parastic diodes 8 are illustrated.

Similarly, the lateral transistor illustrated in FIG. 2.1 has large parasitic diodes at both junctions which degrade performance. The equivalent circuit of the lateral transistor is illustrated in FIG. 2.2.

An integrated circuit embodying the invention and including a symmetrical transistor structure (STS) wherein the area of the top junction is substantially equal to the area of the lower junction is illustrated in FIG. 3. The structure of FIG. 3 includes a vertical bipolar npn transistor 3, a lateral pnp transistor 5 and contiguous self-aligned conductive regions 7. The upper and lower junctions of the vertical bipolar transistor 3 are substantially equal in area as a result of self-aligned fabrication steps to be later described. The structure of FIG. 3 is shown with a buried oxide type isolation 9, however, any other conventional isolation schemes (for isolating the n± sublayer islands of each device) may be used.

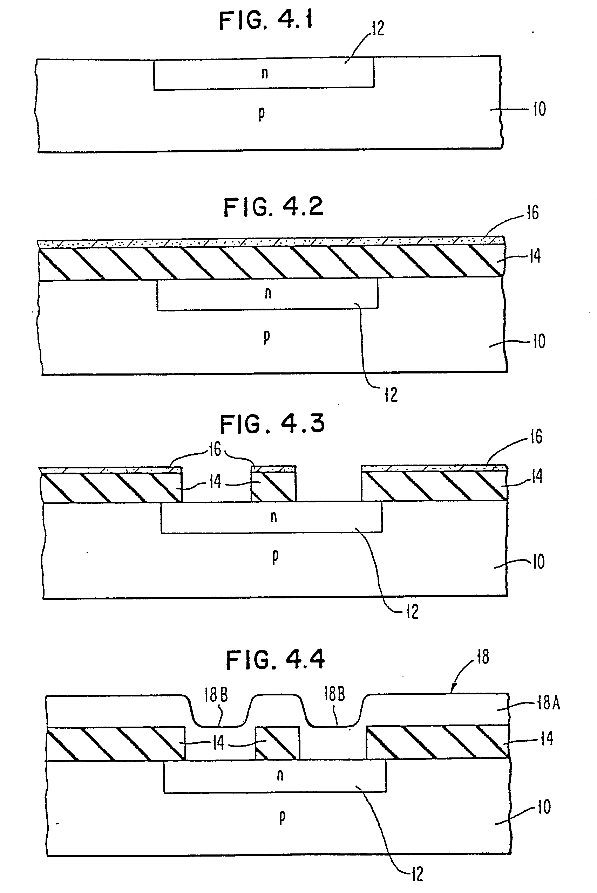

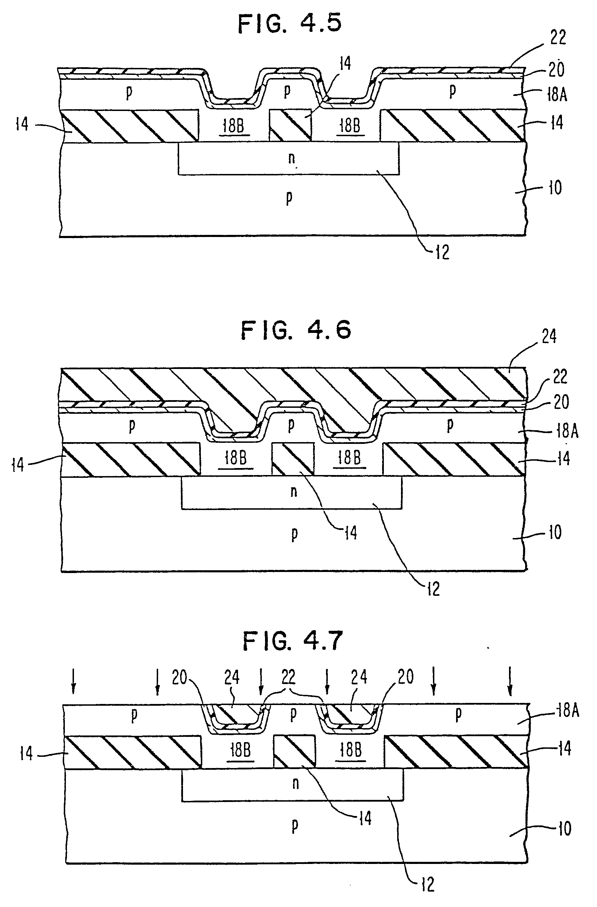

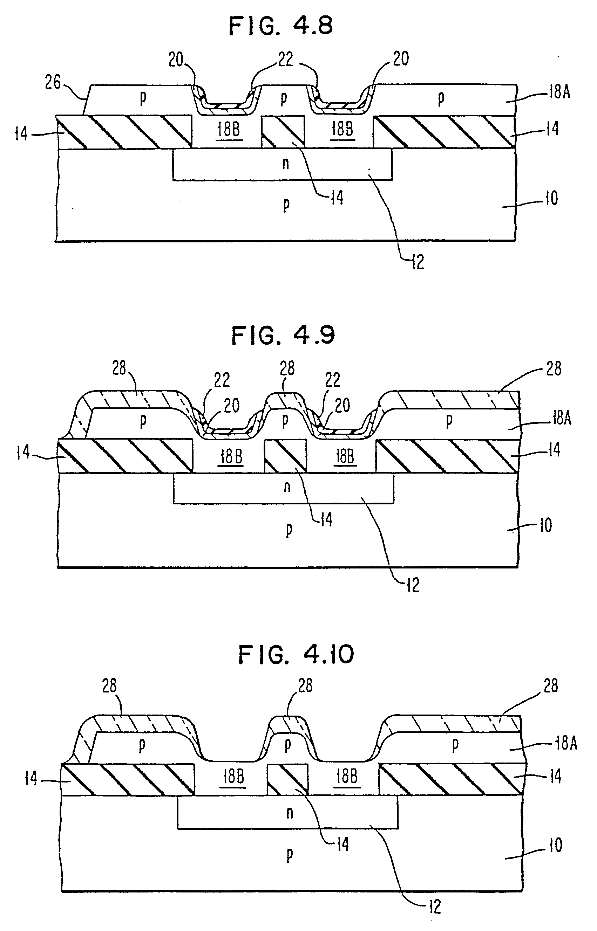

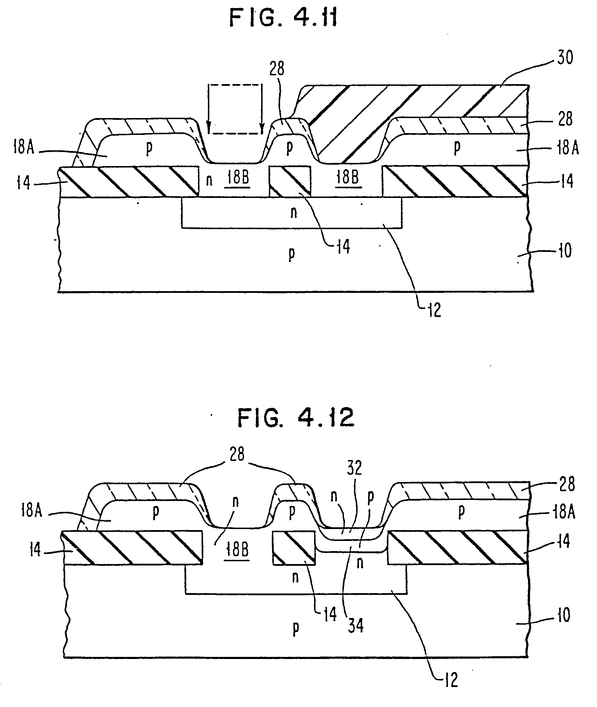

Integrated circuits according to the present invention may be fabricated using several different methods, however, FIGS. 4.1 through 4.12 illustrate an embodiment of a preferred method.

An n+ subcollector region 12 (FIG. 4.1) is ion-implanted in a p-type silicon substrate 10 in a non-critical manner using a first mask. The dopant for the implant may, for example, be arsenic. The structure shown in FIG. 4.1 may be provided with any conventional isolation (not shown), such as recessed oxide or deep trench, to isolate the structure from other devices on an integrated circuit chip.

In FIG. 4.2, a layer of oxide or other suitable insulator 14 is formed on the substrate 10 and subcollector 12 by any suitable technique such as thermal growth, chemical vapour or deposition plasma. A thin layer or skin of silicon 16 is then formed on insulator layer 14 by chemical vapour deposition, sputtering, or other suitable technique, if the semiconductor is silicon as in the general example given. Since its function, if it is employed, is solely as a nucleating layer, layer 16 may or may not be the same as the semiconductor in which the devices are to be built, so long as it serves this function. The layer 16 which functions as a nucleating layer may be of the order of 100 to 800 Angstroms thick when it is silicon. Layer 16 is not however, a critical element in the structure and its use may be eliminated in other embodiments.

In FIG. 4.3, an opening for the active region of the device is defined by etching through layers 16 and 14 using a second mask.

In FIG. 4.4, a layer of lightly doped n-type silicon 18 is deposited.

One deposition technique which may be employed uses silicon tetrachloride and hydrogen wherein $SiCl_4 + H_2$ forms $Si + 4HCl$. The result of this step is that silicon grows simultaneously over the insulator region 14 and over the n+ subcollector 12 regions. The regions grown over the insulator are generally polycrystalline, regions 18A, while the regions grown over the subcollector, regions 18B, are single crystal in nature. It is the case that the single crystal regions partially overgrow the insulator. Laser melting techniques may be employed, if desired, to convert any polycrytalline regions to single crystal regions using the single crystal regions as seed or nucleating sites.

It should be noted that another technique for forming silicon layer 18, for example, is to use silane ($SiH_4$) which decomposes into Si and hydrogen. In this technique the thin layer 16 of silicon of step 4.2 is not required. For both deposition methods appropriate dopant would be incorporated.

In FIG. 4.5 a thin layer of insulator for example silicon dioxide 20 and a thin layer of second insulator, for example, silicon nitride 22 which functions as an oxidation mask, in the case given, are deposited over the semiconductor layer 18, and then the surface of the structure is planarized by spinning on a layer of photoresist 24 or other suitable planarizing material (FIG. 4.6).

The planarizing layer 24 is then uniformly etched for example by reactive ion etching (using $CF_4 + H_2$) or plasma etching. The nitride and oxide layers 22 and 20 respectively over the regions 18A will then be etched away and the etching is stopped when the regions 18A are exposed, leaving regions of planarizing material 24 and nitride 22 and oxide 20 over the regions 18B as illustrated in FIG. 4.7.

Next, a dopant such as boron is ion implanted into the silicon regions 18A to produce p+ conductivity in the case of silicon based vertical npn and lateral pnp structures. It should be noted that the remaining planarizing material 24, nitride layer 22 and oxide layer 20 over the regions 18B function as an implant mask which serves to self-align the region 18B with the p+ conductive regions 18A. Next (FIG. 4.8) the planarizing material 24 is stripped away and the boron is driven in to regions 18A to form p+ contact regions. Then, using a third mask, the region 18A is delineated to separate base regions of different vertical npn transistors as is shown on the left side of FIG. 4.8, feature 26.

In the next step, as illustrated in FIG. 4.9, an oxide layer 28 is grown over the structure, however, the regions 18B will not be oxidized because of the nitride layer 22, which functions as a self-aligned oxide mask.

In FIG. 4.10, the nitride layer over the epi regions 18B is stripped away. Then the thin layer of oxide 20 under the nitride is dip etched away forming a self-aligned top oxide opening over the regions 18B.

In FIG. 4.11, a layer of photoresist 30 is formed and exposed through a fourth mask and then etched to cover the active region of the vertical bipolar device area of the structure. The collector reach through region is then ion-implanted with an n+ dopant, for example with phosphorus.

The vertical bipolar top emitter 32 and base 34 as shown in FIG. 4.12 are then formed by ion-implantation, for example, by implanting boron and arsenic at different dosage and energies after first removing the photoresist mask 30.

Finally, contact holes are formed in the structure of FIG. 4.12 in a conventional manner using a fifth mask, and the structure is metallized conventionally using a sixth mask.

The fabrication steps just set forth relative to FIGS. 4.1 through 4.12 are related to the formation of a vertical bipolar transistor having junction areas of substantially the same size such that the vertical transistor can be operated symmetrically upwards or downwards with equal effectiveness.

To also fabricate, on the same substrate, a symmetrical lateral bipolar transistor having junction areas of substantially the same size and with buried oxide, the method is varied slightly. The fabrication steps illustrated in FIGS. 4.1 through 4.9 are the same.

However, with the structure shown in FIG. 4.9, the oxide layer 20 and nitride layer 22 are not removed and phosphorus is not implanted, so the region 18B remains lightly doped. Instead, a sufficient heat cycle is performed so that the dopant boron in the p+ regions 18A on each side of the n-type region 18B of the device out-diffuses into the n-type region 18B and forms lateral p-n junctions inside the region 18B. After opening contact holes over the p+ regions 18A and metallizing, the lateral p-n-p transistor 5 shown in FIG. 3 is obtained.

## Claims

1. Planar semiconductor integrated circuit including a layer of isolating material (9) disposed over a semiconductor substrate of one conductivity type, the isolating layer being provided with a first hole therethrough having substantially parallel sidewalls and containing semiconductor of the opposite conductivity type, an outer layer (7) of semiconductor of said one conductivity type overlying the isolating layer and a symmetrical vertical bipolar transistor structure (3) comprising a pair of PN junctions formed in a region defined in said outer layer of semiconductor by the hole in the isolating layer, the PN junctions being of substantially equal area and confined to the intrinsic region of the transistor, the circuit being characterised by further including a doped region (12) of semiconductor of said opposite conductivity type formed in the substrate in such a position that it is contiguous with the semiconductor of said opposite conductivity type in the first hole in the isolating layer, and by further including a second symmetrical bipolar transistor structure (5) comprising a pair of PN junctions formed in a region defined in said outer layer of semiconductor by a second hole in the isolating layer, the second hole having substantially parallel sidewalls and containing semiconductor of said opposite conductivity type contiguous with said doped region, the second symmetrical bipolar transistor structure being a lateral transistor structure including a base region of said opposite conductivity type formed in said outer layer and overlying and contiguous with the semiconductor of said opposite conductivity type contained in the second hole in the isolating layer, the PN junctions between the base region and the semiconductor of said one conductivity type of said outer layer being substantially perpendicular to the outer layer and being of substantially equal area.

2. An integrated circuit as claimed in claim 1, in which said outer layer of semiconductor is polycrystalline where it is contiguous with said isolating layer.

3. An integrated circuit as claimed in claim 1, in which said outer layer of semiconductor is monocrystalline.

4. An integrated circuit as claimed in any of claims 1 to 3, in which the substrate consists of p-type silicon, the doped region consists of n-type silicon, the isolating layer consists of silicon dioxide and the outer layer of semiconductor consists of of p-type silicon.

5. An integrated circuit as claimed in any of claims 1 to 3, in which the substrate consists of n-type silicon, the doped region consists of p-type doped silicon, the isolating layer consists of silicon dioxide and the outer layer of semiconductor consists of n-type silicon.

6. A method of fabricating a planar semiconductor integrated circuit including a vertical bipolar transistor having first and second PN junctions of substantially equal area and a lateral bipolar transistor having first and second PN junctions of substantially equal area, the method comprising the steps of:

a. providing (FIG. 4.1) a semiconductor substrate composed of first conductivity type material having a doped region within the surface thereof composed of opposite second conductivity type material,

b. growing (FIG. 4.2) a layer (14) of first insulating material over said substrate and said doped region within said substrate,

c. etching (FIG. 4.3) a hole through said layer of first insulating material over said doped region within said substrate to form an opening in said first insulating material for an active device region,

d. depositing (FIG. 4.4) a layer (18) of lightly doped semiconductor material of second conductivity type over said layer of first insulating material and said opening in said insulating material to simultaneously form a layer of semiconductor material in said active device region over said doped region within said substrate and a conductive layer over said first insulating material,

e. forming (FIG. 4.5) a thin layer (20, 22) of second insulating material over said conductive and semiconductor layer,

f. planarizing (FIG. 4.6) the surface of said structure by applying a layer (24) of planarizing material over said thin layer of second insulating material,

g. etching away (FIG. 4.7) a portion of said layer of planarizing material and said second insulating material to expose said conductive layer (18a) over said first insulating material (14) and to leave a poriton of said layer of second insulating material and said planarizing material over said layer (18b) of semiconductor material in said opening in said first insulating material,

h. implanting (FIG. 4.7) a dopant of said first conductivity type into said conductive layer (18a) disposed over said first insulating material, said layer (18b) of semiconductor material in said opening in said first insulation material being masked by said layer (20, 22) of second insulating material, said layer of second insulating material functioning to self-align said semiconductor material in said opening in said first insulating material with said first conductivity type conductive layer,

i. removing (FIG. 4.8) said planarizing material over said second insulating material (20, 22) and forming (FIG. 4.9) a layer of oxide (28) over said first conductive layer (18a), said layer of semiconductor material in said opening in said first insulating material being masked from oxidation by said layer of second insulating material,

j. forming (FIG. 4.12) first and second (34) transistor regions in said opening in said first insulating material by implanting at least one dopant of said first conductivity type within said layer of lightly doped second conductivity type semiconductor material thereby creating a first junction within said semiconductor material, said first transistor region being of second conductivity type and said second transistor region being of first conductivity type,

k. forming (FIG. 4.12) a third transistor region (32) by implanting at least one dopant of said second conductivity type within said semiconductor layer within said second transistor region thereby forming a second junction between said second transistor region and said third transistor region said first transistor region, said second transistor region and said third transistor region forming a vertical bipolar transistor having first and second junction areas of the same size defined by the width of said active device region in said first insulating material.

7. A method of fabricating an integrated circuit according to claim 6, wherein said semiconductor substrate of step a is composed of silicon, said first insulating material of steb b is composed of silicon dioxide, and said second insulating material of step e is silicon nitride.

8. A method of fabricating an intgegrated circuit according to claim 6 or claim 7, wherein said semiconductor substrate of step a is composed of p-type single crystal silicon, said doped region within said substrate of step a is composed of n-type silicon, said insulating material of step b is silicon dioxide, said layer of lightly doped semiconductor of step d is n-type single crystal silicon, said first transistor region of step j is n-type silicon, and said third transistor region of step k is n-type silicon.

**Revendications**

1. Circuit intégré à semiconducteurs planar comprenant une couche de matériau isolant (9) disposée sur un substrat semiconducteur d'un premier type de conductivité, cette couche isolante étant traversée par une première ouverture à parois latérales sensiblement parallèles et contenant un semiconducteur du type opposé de conductivité, une couche extérieure (7) de semiconducteur du premier type de conductivité recouvrant la couche isolante et une structure (3) de transistor bipolaire vertical symétrique comprenant une paire de jonctions p-n formées dans une région déterminée dans la couche extérieure de semiconducteur par l'ouverture formée dans la couche isolante, les jonctions p-n ayant une superficie sensiblement égale et étant limitées à la région intrinsèque du transistor, ce circuit étant caractérisé en ce qu'il comprend en outre une région dopée (12) de semiconducteur du type opposé de conductivité, formée dans le substrat en un endroit tel qu'elle est contiguë au semiconducteur du type opposé de conductivité dans la première ouverture faite dans la couche isolante; et en ce qu'il comprend en outre une deuxième structure (5) de transistor bipolaire symétrique comportant une paire de jonctions p-n formées dans une région définie dans la couche extérieure de semiconducteur par une deuxième ouverture faite dans la couche isolante, cette deuxième ouverture ayant des parois latérales sensiblement parallèles et contenant un semiconducteur du type opposé de conductivité qui est contigu à la région dopée, cette deuxième structure de transistor bipolaire symétrique étant une structure de transistor latéral comprenant une région de base du type opposé de conductivité, formée dans la couche extérieure et recouvrant et contiguë au semiconducteur du type opposé de conductivité, contenu dans la deuxième ouverture faite dans la couche isolante, les jonctions p-n entre la région de base et le semiconducteur du premier type de conductivité de la couche extérieure étant sensiblement perpendiculaires à la couche extérieure et ayant des superficies sensiblement égales.

2. Circuit intégré suivant la revendication 1, dans lequel la couche extérieure de semiconducteur est polycristalline lorsqu'elle est contiguë à la couche isolante.

3. Circuit intégré suivant la revendication 1, dans lequel la couche extèrieure de semiconducteur est monocristalline.

4. Circuit intégré suivant l'une quelconque des revendications 1 à 3, dans lequel le substrat est constitué de silicium de type p, la région dopée se compose de silicium de type n, la couche isolante est constituée de silice et la couche extérieure de semiconducteur se compose de silicium de type p.

5. Circuit intégré suivant l'une quelconque des revendications 1 à 3, dans lequel le substrat est constitué de silicium de type n, la région dopée se compose de silicium de type p, la couche isolante est constituée de silice et la couche extérieure de semiconducteur se compose de silicium de type n.

6. Procédé de fabrication d'un circuit intégré à semiconducteurs planar comprenant un transistor bipolaire vertical ayant une première et une deuxième jonctions p-n de superficies sensiblement égales et un transistor bipolaire latéral ayant une première et une deuxième jonctions p-n de superficies sensiblement égales, ce procédé comprenant les stades de:

a) fourniture (figure 4.1) d'un substrat semiconducteur composé d'un matériau d'un premier type de conductivité et dans la surface duquel est implantée une région dopée composée d'un matériau d'un deuxième type de conductivité opposé au premier;

b) formation (figure 4.2) d'une couche (14) d'un premier matériau isolant par croissance sur le substrat et sur la région dopée implantée dans le substrat;

c) attaque (figure 4.3) d'une ouverture à travers cette couche de premier matériau isolant au-dessus de la région dopée à l'intérieur du substrat afin de former une ouverture dans le premier matériau isolant vers une région active du dispositif;

d) dépôt (figure 4.4) d'une couche (18) de matériau semiconducteur légèrement dopé, du deuxième type de conductivité, sur la couche de premier matériau isolant et l'ouverture faite dans ce matériau isolant afin de former simultanément une couche de matériau semiconducteur dans la région active du dispositif sur la région dopée formée dans le substrat, et une couche conductrice sur le premier matériau isolant;

e) formation (figure 4.5) d'une couche mince (20, 22) d'un deuxième matériau isolant sur la couche conductrice et sur le matériau semiconducteur;

f) planarisation (figure 4.6) de la surface de la structure par application d'une couche (24) de matériau de planarisation sur la couche mince du deuxième matériau isolant;

g) enlèvement par attaque d'une partie de la couche de matériau de planarisation et du deuxième matériau isolant afin de mettre à nu la couche conductrice (18a) au-dessus du premier matériau isolant (14) et afin de laisser une partie de la couche du deuxième matériau isolant et du matériau de planarisation sur la couche (18b) de matériau semiconducteur dans l'ouverture formée dans le premier matériau isolant;

h) implantation (figure 4.7) d'un dopant du premier type de conductivité dans la couche conductrice (18a) disposée sur le premier matériau isolant, la couche (18b) de matériau semiconducteur dans l'ouverture formée dans le premier matériau isolant étant masquée par la couche (20, 22) du deuxième matériau isolant, cette dernière couche du deuxième matériau isolant ayant pour fonction d'auto-aligner le matériau semiconducteur dans l'ouverture faite dans le premier matériau isolant avec la couche conductrice du premier type de conductivité;

i) enlèvement (figure 4.8) du matériau de planarisation sur la couche (20, 22) du deuxième matériau isolant et formation (figure 4.9) d'une couche d'oxyde (28) sur la première couche conductrice (18a), la couche de matériau semiconducteur dans l'ouverture formée dans le premier matériau isolant étant masquée de l'oxydation par la couche de deuxième matériau isolant;

j) formation (figure 4.12) d'une première et d'une deuxième régions (34) de transistor dans l'ouverture faite dans le premier matériau isolant par implantation d'au moins un dopant du première région de transistor étant du couche de matériau semiconducteur légèrement dopé du deuxième type de conductivité, en créant de ce fait une première jonction à l'intérieur du matériau semiconducteur, la première région de transsistor étant du deuxième type de conductivité tandis que la deuxième région de transistor est du premier type de conductivité.

k) formation (figure 4.12) d'une troisième région (32) de transistor par implantation d'au moins un dopant du deuxième type de conductivité à l'intérieur de la couche de semiconducteur dans la deuxième région de transistor, en formant de ce fait une deuxième jonction entre cette deuxième région de transistor et la troisième région de transistor, la première région de transistor, la deuxième région de transistor et la troisième région de transistor formant un transistor bipolaire vertical dont la première et la deuxième superfices de jonction ont la même dimension déterminée par la largeur de la région active du dispositif dans le premier matériau isolant.

7. Procédé de fabrication d'un circuit intégré suivant la revendication 6, dans lequel le substrat semiconducteur mentionné au stade a) est constitué de silicium, le premier matériau isolant mentionné au stade b) est formé de silice, et le deuxième matériau isolant mentionné au stade e) est du nitrure de silicium.

8. Procédè de fabrication d'un circuit intégré suivant l'une des revendications 6 ou 7, dans lequel le substrat semiconducteur mentionné au stade a) est constitué de silicium monocristallin de type p, la région dopée à l'intérieur du substrat mentionné au stade a) est composée de silicium de type n, le matériau isolant mentionné au stade b) est de la silice, la couche de semiconducteur légèrement dopé mentionnée au stade d) est du silicium monocristallin de type n, la première région de transistor mentionnée au stade j) est du silicium de type n, la deuxième région de transistor mentionnée au stade j) est du silicium de type p, et la troisième région de transistor mentionnée au stade k) est du silicium de type n.

**Patentansprüche**

1. Planare integrierte Halbleiterschaltung bestehend aus einer Schicht Isoliermaterial (9) über einem Halbleitersubstrat einer Leitart, wobei die Isolierschicht mit einem ersten Loch mit weitgehend parallelen Seitenwänden durchbohrt wird und das Loch Halbleiter der entgegengesetzten Leitart enthält, einer äusseren Halbleiterschicht (7) der einen Leitart über der Isolierschicht und einer symmetrischen vertikalen bipolaren Transistorstruktur (3) mit zwei PN-Übergängen in einem durch das Loch in der Isolierschicht abgegrenzten Bereich in der äusseren Halbleiterschicht, wobei die PN-Übergänge im wesentlichen eine gleich grosse Ausdehnung haben und auf den Eigenleitungsbereich des Transistors beschränkt sind, Schaltung dadurch gekennzeichnet, dass sie einen dotierten Bereich (12) von Halbleiter der entgegengesetzten Leitart im Substrat angrezend an den Halbleiter der entgegengesetzten Leitart im ersten Loch der Isolierschicht enthält, und dass sie ausserdem eine zweite symmetrische bipolare Transistorstruktur (5) mit zwei PN-Übergängen in einem in der äusseren Halbleiterschicht durch ein zweites Loch in der Isolierschicht abgegrenzten Bereich aufweist, wobei das zweite Loch weitgehend parallele Seitenwände besitzt und Halbleiter der entgegengesetzten Leitart angrenzend an den genannten dotierten Bereich enthält, wobei die zweite symmetrische bipolare Transistorstruktur eine seitliche Transistorstruktur mit einem in der äusseren Schicht, über dem und angrenzend an den Halbleiter der entgegengesetzten Leitart im zweiten Loch der Isolierschicht liegenden Basisbereich der entgegengesetzten Leitart ist, und die PN-Übergänge zwischen dem Basisbereich und dem Halbleiter der einen Leitart in der äusseren Schicht im wesentlichen senkrecht zur äusseren Schicht sind und im wesentlichen gleich grosse Ausdehnung haben.

2. Eine integrierte Schaltung gemäss Anspruch 1, bei der die äussere Halbleiterschicht dort, wo sie an die Isolierschicht angrenzt, polykristallin ist.

3. Eine integrierte Schaltung gemäss Anspruch 1, dei der die äussere Halbleiterschicht monokristallin ist.

4. Eine integrierte Schaltung gemäss einem der Ansprüche 1 bis 3, bei der das Substrat aus P-leitendem Silizium, der dotierte Bereich aus N-leitendem Silizium, die Isolierschicht aus Siliziumdioxyd und die äussere Halbleiterschicht aus P-leitendem Silizium besteht.

5. Eine integrierte Schaltung gemäss einem der Ansprüche 1 bis 3, bei der das Substrat aus N-leitendem Silizium, der dotierte Bereich aus P-leitendem Silizium, die Isolierschicht aus Siliziumdioxyd und die äussere Halbleiterschicht aus N-leitendem Silizium besteht.

6. Ein Verfahren zur Herstellung einer planaren integrierten Halbleiterschaltung mit einem vertikalen bipolaren Transistor mit im wesentlichen gleich grossen ersten und zweiten PN-Übergängen und einem seitlichen bipolaren Transistor mit im wesentlichen gleich grossen ersten und zweiten PN-Übergängen, wobei sich das Verfahren aus folgenden Schritten zusammensetzt:

a. Bereitstellung (Abb. 4.1) eines Halbleitersubstrats, das aus einem Material einer ersten Leitart mit, in dessen Oberfläche, einem dotierten Bereich aus einem Material einer entgegengesetzten, zweiten Leitart, besteht,

b. Auftragen (Abb. 4.2) einer Schicht (14) eines ersten Isoliermaterials über das Substrat und den dotierten Bereich im Substrat,

c. Ätzen (Abb. 4.3) eines Lochs durch die Schicht des ersten Isoliermaterials über dem genannten dotierten Bereich im Substrat zur Bildung einer Öffnung im ersten Isoliermaterial für einen aktiven Vorrichtungsbereich.

d. Auftragen (Abb. 4.4) einer Schicht (18) leicht dotierten Halbleitermaterials der zweiten Leitart über das erste Isoliermaterial und die Öffnung im Isoliermaterial zur gleichzeitigen Bildung einer Halbleiterschicht im aktiven Vorrichtungsbereich über dem dotierten Bereich im Substrat und einer leitenden Schicht über dem ersten Isoliermaterial,

e. Bildung (Abb. 4.5) einer dünnen Schicht (20, 22) aus einem zweiten Isoliermaterial über der leitenden und der Halbleiter-Schicht.

f. Planarisierung (Abb. 4.6) der Oberfläche der genannten Struktur durch Auftragen einer Schicht (24) Planarisierungsmaterials über der dünnen Schicht aus dem zweiten Isoliermaterial,

g. Wegätzen (Abb. 4.7) eines Teils der Planarisierungsmaterialschicht und des zweiten Isoliermaterials zur Freilegung der leitenden Schicht (18a) über dem ersten Isoliermaterial und Stehenlassen eines Teils der zweiten Isoliermaterialschicht sowie des Planarisierungsmaterials über der genannten Halbleiterschicht (18b) in der Öffnung im ersten Isoliermaterial,

h. Implantation (Abb. 4.7) eines Dotierstoffes der ersten Leitart in die leitende Schicht (18a) über dem ersten Isoliermaterial, wobei die Halbleiterschicht (18b) in der Öffnung im ersten Isoliermaterial durch die Schicht (20, 22) aus dem zweiten Isoliermaterial maskiert ist und die zweite Isolierschicht zur Selbstausrichtung des Halbleitermaterials in der Öffnung im ersten Isoliermaterial mit der leitenden Schicht der ersten Leitart dient,

i. Entfernung (Abb. 4.8) des Planarisierungsmaterials über der zweiten Isolierschicht (20, 22) und Bildung (Abb. 4.9) einer Oxydschicht (28) über der ersten leitenden Schicht (18a), wobei die Halbleiterschicht in der Öffnung im ersten Isoliermaterial durch die zweite Isolierschicht vor der Oxydation geschützt ist,

j. Bildung (Abb. 4.12) eines ersten und zweiten Transistorbereichs (34) in der Öffnung im ersten Isoliermaterial durch Implantation von zumindest einem Dotierungsstoff der ersten Leitart in die leicht dotierte Halbleiterschicht der zweiten Leitart, wodurch ein erster Übergang im Halbleitermaterial entsteht, wobei der erste Transistorbereich von der zweiten Leitart und der zweite Transistorbereich von der ersten Leitart ist,

k. Bildung (Abb. 4.12) eines dritten Transistorbereichs (32) durch Implantation von zumindest einem Dotierungsstoff der zweiten Leitart in die Halbleiterschicht innerhalb des zweiten Transistorbereichs, wodurch ein zweiter Übergang zwischen dem zweiten Transistorbereich und dem dritten Transistorbereich gebildet wird, wobei der erste, zweite und dritte Transistorbereich einen vertikalen bipolaren Transistor mit gleich grossen, durch die Breite des aktiven Vorrichtungsbereich im ersten Isoliermaterial bestimmten ersten und zweiten Übergangsbereichen bilden.

7. Ein Verfahren zur Herstellung einer integrierten Schaltung gemäss Anspruch 6, bei dem das Halbleitersubstrat von Schritt a. aus Silizium, das erste Isoliermaterial von Schritt b. aus Siliziumoxyd und das zweite Isoliermaterial von Schritt e. aus Siliziumnitrid besteht.

8. Ein Verfahren zur Herstellung einer integrierten Schaltung gemäss Anspruch 6 oder 7, bei das Halbleitersubstrat von Schritt a. aus monokristallinen P-leitendem Silizium, der dotierte Bereich im Substrat von Schritt a. aus N-leitendem Silizium, das Isoliermaterial von Schritt b. aus Siliziumdioxyd, die leicht dotierte Halbleiterschicht von Schritt d. aus monokristallinem N-leitendem Silizium, der erste Transistorbereich von Schritt j. aus N-lietendem Silizium, der zweite Transistorbereich von Schritt j. aus P-lietendem Silizium und der dritte Transistorbereich von Schritt k. aus N-leitendem Silizium besteht.

FIG. 1.1

INTRINSIC BASE REGION 31

| n | p |

EXTRINSIC BASE REGION 32

n    n    n

6    4    6

FIG. 1.2

8    8

FIG. 2.1

INTRINSIC BASE EQUIVALENT 34

| p | n | p |
| n | n | n |

EXTRINSIC BASE EQUIVALENT 33

EXTRINSIC BASE EQUIVALENT 33

FIG. 2.2

FIG. 3

p  5      7  n p    3

7              p    n    p        p    7

9      p    n    n    n        9

n

p

12    9

1

FIG. 4.1

FIG. 4.2

FIG. 4.3

FIG. 4.4

2

# FIG. 4.5

# FIG. 4.6

# FIG. 4.7

## FIG. 4.8

## FIG. 4.9

## FIG. 4.10

4

# FIG. 4.11

# FIG. 4.12